Europäisches Patentamt

European Patent Office

Office européen des brevets

(11) Publication number: **0 137 694**
**B1**

# EUROPEAN PATENT SPECIFICATION

(45) Date of publication of patent specification: **19.09.90**

(21) Application number: **84305874.4**

(22) Date of filing: **29.08.84**

(51) Int. Cl.⁵: **H 05 K 3/46,** H 01 P 3/08,
H 05 K 3/30

(54) Printed circuit board maximizing areas for component utilization.

(30) Priority: **30.08.83 US 527841**
**30.08.83 US 527840**

(43) Date of publication of application:
**17.04.85 Bulletin 85/16**

(45) Publication of the grant of the patent:
**19.09.90 Bulletin 90/38**

(84) Designated Contracting States:
**BE DE FR GB IT NL SE**

(56) References cited:
**EP-A-0 027 047**
**EP-A-0 052 738**
**US-A-4 047 132**

**WESCON TECHNICAL PAPER, vol. 26,**
**September 1982, pages 1-8; N. HALES**
**"Multilayer printed circuit boards and their**
**utilization in state-of-the-art digital products"**

(73) Proprietor: **UNISYS CORPORATION**
**1, Burroughs Place**
**Detroit Michigan 48232 (US)**

(72) Inventor: **Barrow, Michael**
**25211 Grissom Road**
**Laguna Hills California 92653 (US)**

(74) Representative: **Kirby, Harold Douglas Benson**
**et al**
**G.F. Redfern & Company Marlborough Lodge 14**
**Farncombe Road**
**Worthing West Sussex BN11 2BT (GB)**

Courier Press, Leamington Spa, England.

## Description

Background of the invention

This invention involves improvements in printed circuit boards and relates specifically to those types of printed circuit boards which bear multiple conductor arrays.

With the constant trend toward miniaturization of electronic components and especially the use of integrated circuitry and integrated circuit chip components which are mounted on printed circuit boards, there is a constant trend toward finding methods of increasing the density of components while minimizing the amont of real estate or printed circuit board area involved both in length, width and also thickness.

There is increasingly a trend toward the use of multilayer printed circuit boards whereby conductive material is separated by insulative material and several layers of such materials are interleaved in order to provide multiple capabilities of interconnection between the electronic components which are mounted on the outer area of the printed circuit board.

By the use of plated-through apertures or "vias", it is possible to interconnect various of the conductive materials on the different layers of the printed circuit board and at the same time, when necessary, provide insulation when the interconnected elements must not contact a certain layer of the interpenetrating via or aperture.

Accordingly, such patents as U.S. Patent 4,362,899 entitled "Printed Circuit Board" indicates types of elements of the construction of multilayered conductive material separated by layers of insulating material and the use of "plated-through holes". Mention here is also made of a ground plane whereby certain shield tracks are connected to the ground plane to provide shielding.

Similarly, U.S. Patent 4,328,531 entitled "Thick Film Multilayer Substrate" involves a technique of construction of multiple conductor layers with dielectric layers interleaved between them. Here, a power supply line is formed in the conductor layer and is interposed between the first and third conductor layers.

It has been found desirable in the design of high density printed circuit boards, which involve the mounting of multiple components, to provide not only voltage and ground connections to various of the electronic components mounted thereon, but it is also necessary to provide interleaved conductive layers to provide connections between various components with each other, and various components with the voltage plane and the ground plane. Further, in order to minimize signal distortion of pulses or waves traveling in the printed circuit conductors, it is most desirable to maintain a constant impedance between various conductors referenced to the voltage plane and ground plane.

US Patent No. 4 047 132 discloses a multilayer printed circuit board including two layers of conductors lying on the same side of, and placed at respective different distances from, a conductive plane. Relative to the conductive plane, the conductors form transmission lines having natural characteristic impedances which vary according to the separation between the respective layers and the conductive plane. There is provided a pattern of one or more conductive areas lying in a plane parallel to said conductive plane, the conductors lying between the conductive plane and the conductive area pattern. The areas of the pattern are connected to the conductive plane and the pattern is configured so as to provide an optimum balance of effective characteristic impedances of the conductors. The conductors in the two planes are mutually perpendicular.

The present disclosure indicates the development of a high density element storage capability on a printed circuit board involving a plurality of conductive layers which may involve up to six conductive layers separated by insulating substrate and wherein there is provided a constant impedance parameter of 100 ohms plus or minus 10% between any conductive line and the voltage plane and between any conductive line and the ground plane of the printed circuit board. This impedance level is a standard requirement for Transistor-Transistor Type (TTL) logic. In addition, there is a standard constraint thickness of printed circuit boards which requires overall thickness if 1.575 mm±.0254 mm (0.062±0.001 inch).

Summary of the invention

It is an object of this invention to provide a multilayered printed circuit board which, while allowing a high density of component mounting per unit surface area will provide for more effective interconnection capability between electronic components mounted on the component surface of the printed circuit board.

It is a further object of the present invention to provide a circuit board which provides a multilayered substrate wherein a plurality of conductive layers are separated by an insulating substrate and whereby the characteristic impedance between any metallic conduction signal plane and a voltage plane or a ground plane will be of a constant nature, in this particular case approximately a constant 100 ohms characteristic impedance, especially suitable for transistor-transistor type logic.

It is a further object of this invention to configure a multilayered printed circuit board having an internal voltage plane and a ground plane on either side of which there are at least two conductive signal layers, again such that the impedance between any signal layer and a voltage plane or any signal layer and a ground plane will always approximate 100 ohms characteristic impedance.

It is a further object of the invention to provide an internal voltage plane and ground plane central to a plurality of conductive signal layers such that there will be no attenuation, alteration or distortion of signals which pass through the signal conductive planes and further there will be no cross talk or cross induction from one signal plane to another.

It is a furtheg object of the invention to provide a multilayered circuit board having internal voltage and ground planes and at least four separate signal planes, yet the board being restricted to a thickness of only $0.1575 \times 10^{-2}$ m $\pm 0.0178 \times 10^{-2}$ m (0.062 of an inch plus or minus 0.007 of an inch).

According to this invention there is provided a printed circuit board comprising: a central dielectric substrate overlaid by a central upper ground and a central lower voltage conductive copper plane, said ground and said voltage conductive copper planes being respectively contiguous to a first internal upper dielectric substrate and a first internal lower dielectric substrate, a first upper and a first lower internal set of co-planar microstrip signal lines respectively contiguous to said first internal upper and first internal lower dielectric substrate, a second upper and a second lower internal dielectric substrate contiguous respectively to said first upper and lower internal sets of microstrip signal lines, a second upper set of co-planar microstrip signal lines and a second lower set of co-planar microstrip signal lines placed respectively contiguous to said second internal upper and lower dielectric substrates, the lines in said second upper set running in a direction at right angles to the lines in said first upper set and the lines in said second lower set running in a direction at right angles to the lines in said first lower set, characterised in that the overall thickness of said printed circuit board is less than 1.75 mm (69 mil), in that the microstrip signal lines have a characteristic impedance of 100 ohms $\pm 10\%$, in that the central dielectric substrate has a dielectric constant of from 4.2—5.0, in that said voltage and said ground conductive copper planes have a thickness of 0.036 mm (1.4 mil), in that said first internal upper dielectric substrate and said first internal lower dielectric substrate have a thickness of 0.597—0.673 mm (25 mil $\pm 1.5$ mil) and a dielectric constant of from 4.2—5.0, in that the lines in said first upper and said first lower sets have a width of 0.102—0.152 mm (5 mil $\pm 1$ mil) and a thickness of 0.018 mm (0.7 mil) and the lines in said first upper set run at right angles to the lines in said first lower set, in that said second upper and said second lower substrates have a thickness of 0.038—0.114 mm (3 mil $\pm 1.5$ mil), and in that the lines in said second upper and said second lower sets have a thickness of 0.2 mm (8 mil) and a width of 0.036 mm (1.4 mil) and the lines in said second upper set run in a direction at right angles to the lines in said second lower set. (Note: the NEMA (National Electrical Manufacturers Association) manual defines a one ounce weight characteristic as the deposition of one ounce of copper deposited evenly on a one square foot area).

It is the particular thickness of the various signal line planes and the separation distances between the signal planes and the voltage plane (and or ground plane) that make it possible for there to exist a constant impedance of 100 ohms between any signal line and the voltage plane or between any signal line and the ground plane.

It is desirable that a constancy of impedance be established since this will ensure that all signals operating on the signal lines will see the same impedance and no one signal will be changed or distorted disproportionately in relationship to another signal line.

Brief description of the drawings

Fig. 1 is an expanded cross-section drawing which shows the multilayered printed circuit board with four signal conducting planes, two at the top of the component side and two at the bottom on the solder side, in addition to the internal voltage plane and conductive ground plane;

Fig. 2 is an isometric drawing showing a cross-section of the printed circuit board indicating the various conductive planes separated by the substrate and also illustrating examples of plated-through holes whereby it is possible to make electrical connection between various of the inner and outer layers of the multilayered printed circuit board;

Fig. 3 is a schematic drawing showing the overall printed circuit board with slide-in connector pins at one edge and also the orientation of the various signal lines of different layers;

Fig. 4a shows a cross-section of a signal line for an "external" plane while Fig. 4B shows the signal line cross-section for an "internal" plane;

Fig. 5 illustrates a concept involving interconnect capability involving the number of conductors per square inch of surface on the printed circuit board;

Fig. 6 illustrates a 16 mil grid arrangement.

Description of preferred embodiment

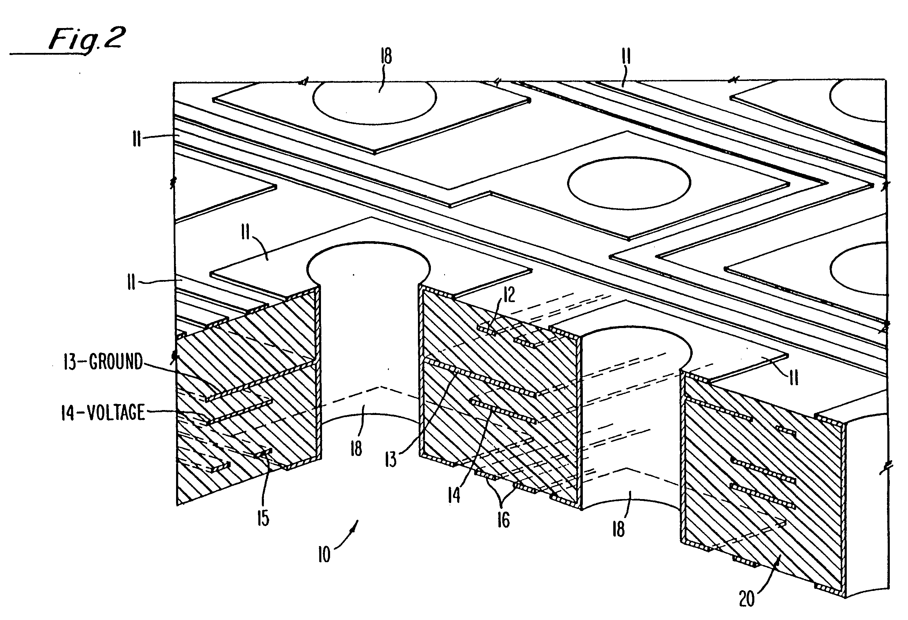

Fig. 2 shows a cross-sectional cutout of a portion of a printed circuit board built according to the subject invention. The printed circuit board 10 is shown having a top extenal layer plane or "component side" layer 11 and the external lower side or "solder side" layer plane 16. Further, there is shown the internal upper signal layer plane 12, the ground plane 13, the voltage plane 14, the internal lower signal layer plane 15 and the external lower signal layer plane 16 (which corresponds to the sixth layer 16 of deposition on the substrate).

The plated-through holes 18 may be used to connect any of the signal planes to the top layer signal plane which holds the components or to the ground plane or voltage plane as may be necessary. Likewise, the hole 18 may not be plated-through, that is it may be insulated so as not to connect, and thus to maintain the insulation as between any two conductive layers.

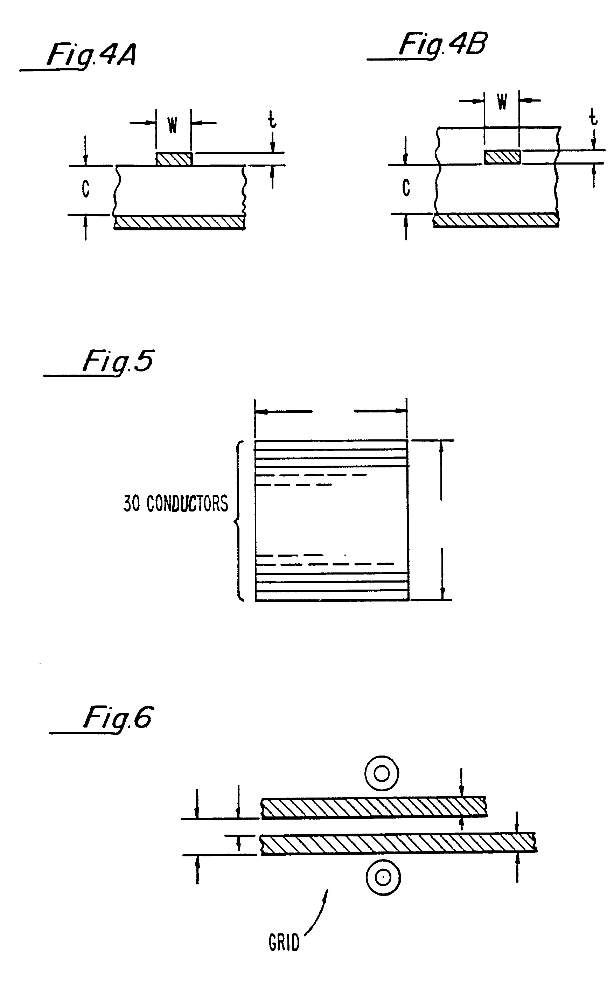

Fig. 3 shows the printed circuit board in perspective and having slide-in connector pins along one edge. The solid lines illustrate the orientation of the top external and the lower internal signal lines while the broken lines show the top internal and lower external signal lines.

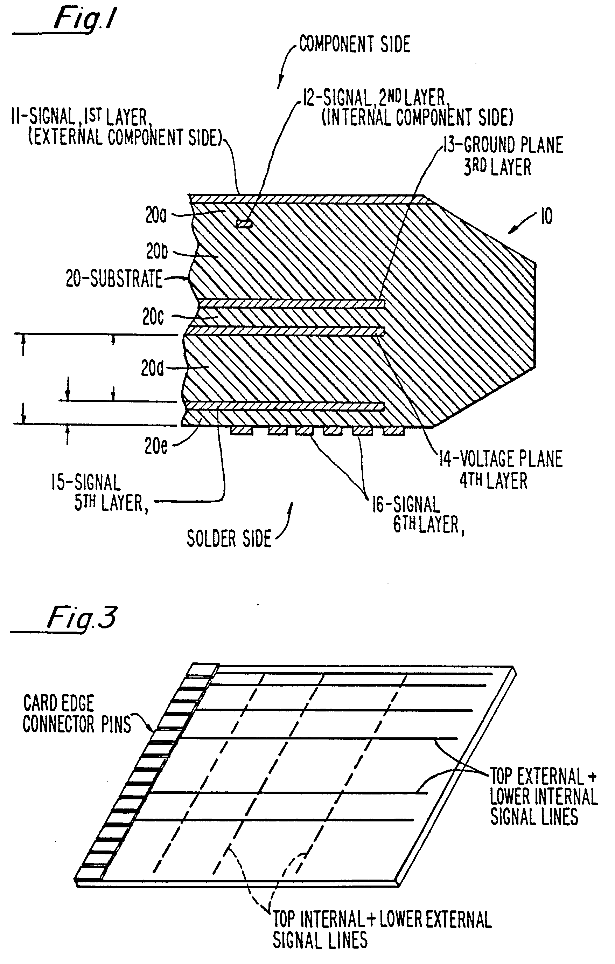

Referring to Fig. 1 there is seen a cross-sectional view of the multilayered printed circuit board of the present disclosure. The top or component side is a signal plane 11 having a first layer of conductive copper upon which there may be connceted or placed various electronic components. It is important to note that the size of this particular plane is critical to the configuration and thus the first layer is a 0.2 mm (eight mil) thickness line (or a plurality of such lines) and is designated as a one ounce weight characteristic, having a width of 0.036 mm (0.0014 inches or 1.4 mils).

Directly beneath the first signal layer 11 there is a substrate portion $20_a$ having a thickness of 0.076 mm (0.003 of an inch (3 mils)) after which there is placed another conductive plane 12. This may be called the second signal layer and it is made of a 0.127 mm (five mil) width line ±0.025 mm (plus or minus one mil) and can be designated as a one-half ounce weight characteristic having a wifth of 0.018 mm (0.0007 inches or 0.7 mils). This second signal layer may consist of a plurality of separate signal lines of 0.127 mm (5 mil) width which run at right angles to the lines of the first signal layer.

Between the second signal layer 12 and the ground plane 13 there is a substrate 20b of thickness equal to 0.0635 mm±0.038 mm (0.025 of an inch (25 mils) plus or minus 1.5 mils) after which there is seen the ground plane 13 having a one ounce characteristic or thickness of 0.036 mm (1.4 mils).

Separararating the ground plane 13 from the voltage plane 14 there is a substrate having a thickness of 0.127 mm (0.005 of an inch or 5 mils).

The voltage plane 14 may be considered as being the fourth layer from the top or component side while the ground plane 13 could be considered the third layer. The voltage plane 14 is used to carry power, that is voltages and currents which are to be connected to various of the elements mounted on the component side of the printed circuit board 10 of Fig. 1.

Element No. 15 represents the fifth layer from the top and constitutes a plurality of signal lines in a plane wherein each one of the signal lines is "internal" and constitutes a 0.127 mm (five mil) width line for carrying signals between various components on the component side which may be connected to the signal line through the plated-through connectors 18 shown in Fig. 2. The fifth layer 15 represents a series or plurality of signal lines which run basically at right angles to the second signal layer 12 and to the sixth layer 16 of signal lines.

The sixth layer 16 is a signal line which is separated from the fifth layer 15 signal line by the portion of substrate designated $20_e$ which is in the range of 0.076 mm±0.038 mm (3 mils plus or minus 1.5 mils). The sixth layer is the signal layer 16 and is made of a 0.2 mm (eight mil) width line. A plurality of such 0.2 mm (8 mil) width lines may constitute the sixth layer as seen as elements 16 of Fig. 1. These lines run at right angles to the lines of the first signal layer 11. This sixth layer represents the solder side where a solder bath may be used to make interconnections at this lower external side.

In order to calculate the impedance (Fig. 4A) between an "external" signal line (microstrip) and ground, or the "external" signal line and the voltage plane, it is required that use be made of the impedance formula:

$$Z_o = \frac{60}{\sqrt{0.475 \times E_r + 0.67}} \ L_n \left( \frac{5.98 \times C}{0.8 \ W + t} \right)$$

where

$E_r$ = dielectric constant for material substrate, for example, epoxy glass = 4.2—5.0
W = width of conductor, in mils
t = thickness of conductor, in mils
C = dielectric thickness, in mils
$L_n$ = natural logarithm.

The above formula is derived for a rectangular microstrip having width W and thickness t as seen in Figs. 4A and 4B. Similar type impedance derivations are performed for circular microstrip in an article entitled "Characteristics of Microstrip Transmission Lines" by H. R. Kaupp published in IEEE Transactions on Electronic Computers, Vol. EC-16, No. 2, April 1967 at pages 185—193.

Thus, for an "external" signal line, if the impedance $Z_o$ is plotted on a chart for a line having a 0.2 mm (8 mil) width (W) and a 0.036 mm (1.4 mil) thickness, then this would require that the dielectric thickness C (distance between the external signal level plane and the adjacent ground plane or voltage plane) should be approximately 0.71 mm (28 mils) in order to provide a 100 ohm line impedance.

For the "internal" signal microstrip line (Fig. 4B), the impedance formula is:

$$Z_o = \frac{60}{\sqrt{E_r}} \ L_n \left( \frac{5.98 \times C}{0.8 \ W + t} \right)$$

Here, if the impedance $Z_o$ is plotted for a line having a 0.127 mm (5 mil) width and 0.018 mm (0.7 mil) thickness (one-half ounce characteristic), then the dielectric thickness C (distance between the "internal" signal plane and the adjacent voltage or ground plane) should be approximately 0.635 mm (25 mils) in order to provide a 100 ohm characteristic impedance.

Another feature of the multilayer printed circuit board is its higher capability for interconnections between the mounted component units through the internal layered lines.

For example, the component side of the printed circuit board may support a variety of integrated circuit chips which have various configurations of output connection pins. These may vary from a 10×10 grid of output connections, or 20 pin output connections, or 28 pin output connections, etc. Thus, the surface of the board must be compatible to permit these type of connections to occur without interference to the conducting lines on the first layer signal plane on the top external component side of the printed circuit board.

The density involved in a printed circuit board design can be expressed as line resolution—i.e., the dimension of the conductor width and the dielectric space. Presently many high density boards are those designed primarily with two conductors routed between holes on 2.54 mm (100 mil) centers using a 0.2 mm (8 mil) conductor and a 0.2 mm (8 mil) dielectric space.

For random logic usage the required length of conductor needed per unit board area (or the interconnect capacity) of a printed circuit board to connect a given number of I/O pins has been empirically determined and it can be generally expressed by the formula as follows:

$$C_i = \frac{M \times N}{A}$$

Where M is a constant with certain values as follows:

M=76.2 mm (3.0") per pin for two signal layers

M=88.9 mm (3.5") per pin for four signal layers

$C_i$=interconnect capacity

N=number of I/O pins within an area

A=area available for routing

The interconnect capacity "$C_i$" for one signal layer using a 0.4 mm (16 mil) grid is, on the average 762 mm per 645.2 mm² (30" per square inch). Thus, if we let the symbol $K_{16}$=762 mm per 645.2 mm² (30" per square inch) and let

$$L_y = \frac{C_i}{K_{16}}$$

then $L_y$ is the number of layers required to route a given number of pins in a given area. The concept of interconnect capacity, $C_i$, is illustrated in Fig. 5 to show that 30" inches per square inch" means a board area of 645.2 mm² (one square inch) having 30 microstrip conductors.

Thus, it is possible to determine how many layers $L_y$ are required to route a 68 pin chip carrier on a routing area of 2193.5 mm² (3.4 square inches).

Interconnect capacity

$$C_i = \frac{76.2 \times 68}{3.4 \times 645.2} \left( \frac{3 \times 68}{3.4} \right)$$

$C_i$=1524 mm per 645.2 mm² (60 inches per square inch), and

$$L_y = \frac{1524}{762} \left( \frac{60}{30} \right)$$

$L_y$=2 layers.

Thus, "two" signal layers are required to successfully route this chip in the particular area provided. It should be noted that as chips are placed closer together on a printed circuit board, the area for routing is decreased and thus "additional" signal layers must be provided in accordance with the above stated equations.

The table shown below as Table I shows the minimum routing areas required for various packages using a 0.4 mm (16 mil) grid on both two and four layer signals. Reference to Fig. 6 will illustrate the 0.4 mm (16 mil) grid.

TABLE I

| | | Pins/package | 2 Signal layers routing area mm²(In²) | 4 Signal layers routing area mm²(In²) | Area saved | % of area saved with 4 layers over 2 layers |
|---|---|---|---|---|---|---|
| | | 14 | 451.64(0.70) | 258.08(0.40) | 193.56(0.30) | 43% |
| Dips | 7.62 mm (0.3 in) center line 15.24 mm (0.6 in) center line | 16 | 516.16(0.80) | 303.24(0.47) | 212.92(0.33) | 41% |
| | | 18 | 580.68(0.90) | 341.96(0.53) | 238.72(0.37) | 41% |
| | | 20 | 645.2 (1.00) | 374.21(0.58) | 270.98(0.42) | 42% |
| | | 24 | 774.24(1.20) | 671.01(1.04) | 103.23(0.16) | 13% |
| | | 28 | 903.28(1.40) | 722.62(1.12) | 180.66(0.28) | 20% |
| Chip carriers | | 40 | 1290.4(2.00) | 1083.94(1.68) | 206.46(0.32) | 16% |
| | | 68 | 2193.68(3.40) | 1277.50(1.98) | 916.18(1.42) | 42% |
| | | 84 | 2709.84(4.20) | 1580.74(2.45) | 1129.1(1.75) | 42% |
| | | 120 | 3871.2(6.00) | 2258.2(3.50) | 1613.0(2.50) | 42% |
| | | 156 | 5032.56(7.80) | 2935.66(4.55) | 2096.9(3.25) | 42% |

NOTE: This shows a minimum routing area required for 2 and 4 signal layers with a 0.4 mm (16 mil) grid (Fig. 6).

To estimate the number of packages a particular board style can accommodate, the total routing area of the packages must be compared to the available routing area on the printed circuit board.

For example, it may be required to know how many 16-pin "dips" (Dual In-Line Packages) can an electrical interface board accommodate with two signal layers using a 0.4 mm (16 mil) grid?

Let us say the electrical interface board has 14 square inches of usable routing area. Now according to Table I, it an be seen that 16 pin "dips" require 516.16 mm² (0.8 square inches) of routing area when using two signal layers.

$$\text{Number of 16-pin packages} = \frac{\text{Usable area on board}}{\text{Minimum area required for 16 pins}}$$

$$= \frac{9032.8}{516.16} \qquad \frac{14 \text{ square inches}}{0.8 \text{ square inches}}$$

$$= 17.5$$

$$= 18 \text{ approximately}$$

Thus, a board having 9032.8 mm² (14 square inches) of area and two layers of signal planes can accommodate 18 "dips" of 16 pins each.

# EP 0 137 694 B1

The limiting factor for board density may not always be the routability (which itself is limited by profile of the package) but also the power density that the board can dissipate in a given environment.

However, using the above data, it is now possible to set design parameters for printed circuit boards to maximize the interconnect capability when knowing the available board area and the type of carrier components to be mounted on the printed circuit board.

There has thus been described a multilayer printed circuit board which is capable of high density packaging in that the multiple number of signal conduction planes make it possible to interconnect a large quantity of electronic components; further, the configuration as to the placement and width of the signal conducting lines or layers in relationship to the spacing or width of the dielectric substance used thus makes it possible to design a configuration which provides an essentially 100 ohm characteristic impedance to all signal lines when they are referenced either to the voltage plane or to the reference plane. Thus, there is a constancy of signal fidelity and an absence of leakage or cross talk.

## Claims

1. A printed circuit board comprising: a central dielectric substrate (20c) overlaid by a central upper ground (13) and a central lower voltage (14) conductive copper plane, said ground and said voltage conductive copper planes being respectively contiguous to a first internal upper dielectric subtrate (20b) and a first internal lower dielectric substrate (20d), a first upper (12) and a first lower (15) internal set of co-planar microstrip signal lines respectively contiguous to said first internal upper (20b) and first internal lower (20d) dielectric substrate, a second upper (20a) and a second lower (20e) internal dielectric substrate contiguous respectively to said first upper (12) and lower (15) internal sets of microstrip signal lines, a second upper set of co-planar microstrip signal lines (11) and a second lower set of co-planar microstrip signal lines (16) placed respectively contiguous to said second internal upper (20a) and lower (20e) dielectric substrates, the lines in said second upper set (11) running in a direction at right angles to the lines in said first upper set (12) and the lines in said second lower set (16) running in a direction at right angles to the lines in said first lower set (15), characterised in that the overall thickness of said printed circuit board is less than 1.75 mm (69 mil), in that the microstrip signal lines have a characteristic impedance of 100 ohms ±10%, in that the central dielectric substrate (20c) has a dielectric constant of from 4.2—5.0, in that said voltage (14) and said ground (13) conductive copper planes have a thickness of 0.036 mm (1.4 mil), in that said first internal upper dielectric substrate (20b) and said first internal lower (20d) dielectric substrate have a thickness of 0.597—0.673 mm (25 mil ±1.5 mil) and a dielectric constant of from 4.2—5.0, in that the lines in said first upper (12) and said first lower (15) sets have a width of 0.102—0.152 mm (5 mil±1 mil) and a thickness of 0.018 mm (0.7 mil) and the lines in said first upper set (12) run at right angles to the lines in said first lower set (15), in that said second upper (20a) and said second lower (20e) substrates have a thickness of 0.038—0.114 mm (3 mil+1.5 mil), and in that the lines in said second upper (11) and said second lower (16) sets have a thickness of 0.2 mm (8 mil) and a width of 0.036 mm (1.4 mil) and the lines in said second upper set (11) run in a direction at right angles to the lines in said second lower set (16).

2. A printed circuit board according to Claim 1, wherein said second upper (11) and said second lower (16) sets of signal lines constitute external signal lines.

3. A printed circuit board according to Claim 2, wherein said second upper set of signal lines (11) includes a plurality of conductive land areas having central apertures (18) for connection of component leads.

## Patentansprüche

1. Eine gedruckte Leiterplatte mit: einem zentralen dielektrischen Substrat (20c), über dem eine zentrale obere die Masse (13) und eine zentrale untere eine Spannung (14) führende Kupferschicht liegt, wobei die die Masse und die Spannung führenden Kupferschichten entsprechend benachbart zu einem ersten, inneren, oberen dielektrischen Substrat (20b) und einem ersten, inneren, unteren dielektrischen Substrat (20d) angeordnet sind, einer ersten oberen (12) und einer ersten unteren (15) inneren Gruppe von koplanaren mikrostreifenförmigen Signalleitungen, die entsprechend benachbart zu dem ersten inneren, oberen (20b) und ersten inneren, unteren (20d) dielektrischen Substrat angeordnet sind, einem zweiten oberen (20a) und einem zweiten unteren (20e), inneren dielektrischen Substrat, das entsprechend benachbart zu den ersten oberen (12) und unteren (15) inneren Gruppe von mikrostreifenförmigen Signalleitungen angeordnet sind, einer zweiten oberen Gruppe von koplanaren mikrostreifenförmigen Signalleitungen (11) und einer zweiten unteren Gruppe von koplanaren mikrostreifenförmigen Signalleitungen (16), die entsprechend benachbart zu den zweiten inneren, oberen (20a) und unteren (20e) dielektrischen Substraten angeordnet sind, wobei die Leitungen in der zweiten oberen Gruppe (11) in einer Richtung rechtwinklig zu den Leitungen in der ersten oberen Gruppe (12) verlaufen und die Leitungen in der zweiten unteren Gruppe (16) in einer Richtung rechtwinklig zu den Leitungen in der ersten unteren Gruppe (15) verlaufen, dadurch gekennzeichnet, daß die gesamte Dicke der gedruckten Leiterplatte geringer als 1,75 mm (69 mil) ist, daß die mikrostreifenförmigen Signalleitungen einen Leitungswellenwiderstand von 100 Ohm ±10% besitzen, daß das zentrale dielektrische Substrat (20c) eine dielektrische Konstant von 4,2—5,0 besitzt, daß die die Spannung (14) und die Masse (13) führenden

7

Kupferschichten eine Dicke von 0,036 mm (1,4 mil) besitzen, daß das erste innere, obere dielectrische Substrat (20b) und das erste innere, untere (20d) dielektrische Substrat eine Dicke von 0,597—0,673 mm (25 mil±1,5 mil) und eine dieletrische Konstante von 4,2—5,0 besitzen, daß die Leitungen in den ersten oberen (12) und den ersten unteren (15) Gruppen eine Breite von 0,102—0,152 mm (5 mil±1 mil) und eine Dicke von 0,018 mm (0,7 mil) besitzen und die Leitungen in der ersten oberen Gruppe (12) rechtwinklig zu den Leitungen in der ersten unteren Gruppe (15) verlaufen, daß die zweiten oberen (20a) und die zweiten unteren (20e) Substrate eine Dicke von 0,038—0,114 mm (3 mil±1,5 mil) besitzen und daß die Leitungen in den zweiten oberen (11) und den zweiten unteren (16) Gruppen eine Dicke von 0,2 mm (8 mil) und eine Breite von 0,036 mm (1,4 mil) besitzen und die Leitungen in der zweiten oberen Gruppe (11) in einer Richtung rechtwinklig zu den Leitungen in der zweiten unteren Gruppe (16) verlaufen.

2. Eine gedruckte Leiterplatte nach Anspruch 1, bei welcher die zweiten oberen (11) und die zweiten unteren (16) Gruppen von Signalleitungen externe Signalleitungen bilden.

3. Eine gedruckte Leiterplatte nach Anspruch 2, bei welcher die zweite obere Gruppe von Signalleitungen (11) eine Vielzahl von leitenden Anschlußflächen mit Zentralöffnungen (18) für den Anschluß von Komponentendrähten aufweist.

**Revendications**

1. Plaque de circuit imprimé comprenant:

un support diélectrique central (20c) recouvert d'une base supérieure centrale (13) et d'un plan en cuivre conducteur (14) formant un plan de tension inférieur central, le plan de masse et le plan de cuivre conducteur de tension étant respectivement adjacents à un premier support diélectrique supérieur interne (20b) et un premier support diélectrique inférieur interne (20d), un premier jeu supérieur (12) et un seconde jeu inférieur (15) interne de lignes de signaux à microbande, coplanaires, respectivement adjacents au premier support diélectrique supérieur interne (20b) et au premier support diélectrique interne inférieur (20d), un second support diélectrique interne supérieur (20a) et un second support diélectrique interne inférieur (20e) étant respectivement adjacents au premier ensemble supérieur (12) et à l'ensemble inférieur (15) de lignes de signaux à microbande, un second ensemble supérieur de lignes de signaux (11) en microbande coplanaires et un second ensemble de lignes de signaux, en microbande, coplanaires (16) étant respectivement adjacents au second support supérieur interne (20a) et au second support inférieur diélectrique (20e), les lignes du second ensemble supérieur (11) étant perpendiculaires aux lignes du premier ensemble (12) et les lignes du second ensemble inférieur (16) circulant dans une direction perpendiculaire aux lignes du premier ensemble inférieur (15), circuit caractérisé en ce que l'épaisseur totale de la plaque de circuit imprimé est inférieure à 1,75 mm (69 mils), en ce que les lignes de signaux de microbande présentent une impédance caractéristique de 100 ohms±10%, en ce que le support diélectrique central (20c) a une constante diélectrique égale à 4,2—5,0, en ce que le plan de cuivre conducteur formant le plan de tension (14) et le plan de masse (13) a une épaisseur de 0,036 mm (1,4 mil), et en ce que le premier support diélectrique supérieur interne (20b) et le premier support diélectrique interne inférieur (20d) ont une épaisseur de 0,597—0,673 mm (25 mils±1, mil) et une constante diélectrique de 4,2—5,0 et en ce que les lignes du premier ensemble supérieur (12) et du premier ensemble inférieur (15) ont une largeur de 0,102—0,152 mm (5 mils±1 mil) et une épaisseur de 0,018 mm (0,7 mil) et les lignes du premier ensemble supérieur (12) sont perpendiculaires aux lignes du premier ensemble inférieur (15); en ce que le second support supérieur (20a) et le second support inférieur (20e) ont une épaisseur de 0,038—0,114 mm (3 mils±1,5 mil) et en ce que les lignes dans la seconde partie supérieure (11) et la seconde partie inférieure (16) ont une épaisseur de 0,2 mm (8 mils) et une largeur de 0,036 mm (1,4 mil) et les lignes du second ensemble supérieur (11) sont dirigées dans une direction perpendiculaire aux lignes du second ensemble inférieur (16).

2. Plaque de circuit imprimé selon la revendication 1, caractérisée en ce que le second ensemble supérieur (11) et le second ensemble inférieur (16) des lignes de signaux constituent des lignes de signaux externes.

3. Plaque de circuit imprimé selon la revendication 2, caractérisée en ce que le second ensemble supérieur de ligne de signaux (11) comprend un ensemble de surfaces conductrices ayant des ouvertures centrales (18) pour la connexion des conducteurs des composants.

Fig.1

Fig.3

Fig.2

_Fig.4A_

_Fig.4B_

_Fig.5_

30 CONDUCTORS

_Fig.6_

GRID

3